## Europäisches Patentamt
## European Patent Office
## Office européen des brevets

(19)

(11) Publication number: **0 058 982**
**B1**

(12)

# EUROPEAN PATENT SPECIFICATION

(45) Date of publication of patent specification: **27.12.84**

(21) Application number: **82101340.6**

(22) Date of filing: **22.02.82**

(51) Int. Cl.³: **H 04 M 11/06,** H 03 K 13/01, G 01 R 23/167

(54) **Digital device for discriminating between digitized speech signals and data signals.**

(30) Priority: **24.02.81 IT 6725181**

(43) Date of publication of application:
**01.09.82 Bulletin 82/35**

(45) Publication of the grant of the patent:
**27.12.84 Bulletin 84/52**

(84) Designated Contracting States:
**BE CH DE FR GB LI NL SE**

(56) References cited:
**FR-A-2 321 219**
**US-A-3 708 746**

**International Conf. on Acoustics Speech and Signal Processing, Hartford 1977 pages 332-335**

(73) Proprietor: **CSELT Centro Studi e Laboratori Telecomunicazioni S.p.A.**
**Via Guglielmo Reiss Romoli, 274**
**I-10148 Turin (IT)**

(72) Inventor: **Castellino, Paolo**
**Via Filadelfia, 51**
**Turin (IT)**
Inventor: **Rusina, Fulvio**
**Via delle Ginestre, 3**
**Cirié - Torino (IT)**

(74) Representative: **Riederer Freiherr von Paar zu Schönau, Anton et al**
**Freyung 615 Postfach 2664**
**D-8300 Landshut (DE)**

## Description

The present invention concerns speech data integrated networks, and more particularly it relates to a digital device inserted in the telephone exchange for discriminating speech signals from data signals, both encoded in digital form, e.g. PCM signals.

Systems particularly suited to increase the number of speech communications without increasing the whole bit rate, are well known. Said systems are based on the differential coding and are usually known as ADPCM (Adaptive Differential PCM) or ADM (Adaptive Delta Modulation). In other systems, such as DISI (Digital Speech Interpolation) the assignment of the available communication channel to the speaker depends on his actual activity.

All the above-mentioned systems nearly double the channel capacity.

A system which combines both techniques, attaining an increase in the number of communications equal to about 7 times the previous one, is described in the paper entitled "A high-gain DSI-ADPCM system" relating to the records of the IC ASSP (International conference on Acoustics Speech and Signal Processing) held at Washington in 1979.

Said systems and more particularly ADPCM systems are obviously useless and even detrimental if indiscriminately applied also to voice band modulated data signals; however if data rate is low enough and does not exceed 2400 bit/s, damages as to the relevant transmission errors are practically negligible. At higher rate, on the contrary, errors would be too many and at 4800 bit/s, for instance, their quantity would be intolerable.

As known, in fact, digital-data transmission is obtained by voice-band modulation, through a modem, of base-band generated binary data; the voice-band analog signal attains the telephone exchange where it is time-sampled and converted into digital form, e.g. PCM. In the same exchange also speech signals are PCM encoded and frames are built up consisting of speech signals and partially of data signals.

Consequently, as both speech and data signals transit through a speech data integrated network, at the input of possible redundancy-reducing systems the two kinds of signals ought to be discriminated in order to process them differently.

Known from the literature ("On line speech data modem identifier for telephone network", paper presented at the IC ASSP congress at Hartford, 1977) is a system effecting this discrimination on the basis of some typical signal parameters (such as: logarithmic average, magnitude, greatest sample magnitude, zero-crossings of the signal and derived signal) and on the basis of comparisons with suitable threshold.

More particularly a discriminating function on the plane R, Z is built up, where $R=(\dot{A}_n-A_n)/2$, where $A_n$ represents the greatest sample signal in a block of PCM samples relating to 8 ms duration, $A_n$ is the logarithm of the average of the moduli of such samples, Z is the number of zero crossings of the samples of the block of 8 ms. However, according to the author's statements, a right classification is difficult especially for unvoiced sounds, such as "sc" $[\int]$ in the Italian "sciare" verb. Therefore to check erroneous decisions a smoothing network can be provided that introduces a decision delay, that, as known, is detrimental to long-distance communication purposes. This known system discriminates between speech and data signals, even when it would be unnecessary, as low-rate data are concerned. Under these conditions, discrimination errors may take place as the speech signal may approximate for a given time period the time and spectral characteristics of the data signal.

As a consequence in case of differential encoding systems two kinds of disadvantages may be encountered:

— in case of speech transmission misinterpreted as data transmission there is an unjustified decrease in the overall channel transmission capacity. The system in fact does not affect a redundancy reduction, therefore it assignes a bit number greater than needed to speech signals;
— in case of data transmission misinterpreted as speech signal, there is an unjustified fictitious redundancy reduction, which can easily generate at least phase errors and/or delay errors; which errors are due to the fact that when effecting a speech-data conversion and vice versa, the signal is routed along two different paths, of which the one comprising the redundancy reducer certainly affects the phase.

Besides, due to the unusual nature of these kinds of errors introduced by the known discrimination devices, if the data transmission system is not sufficiently protected against these particular errors a single error may propagate itself, possibly in a catastrophic way, to the rest of the transmission.

Analogously for DSI systems, as a determined number of channels has generally been assigned to data transmission, when a speech signal is generally erroneously classified as a data signal the consequence may be a subtraction of a data channel; vice versa, if a data signal has been wrongly classified as a speech signal, from the samples of said data signal, under high-traffic conditions one or more bits can be subtracted, as known, increasing in that way the error probability.

A solution to said problems is provided by the present invention of a device for the discrimination of speech signals from data signals and of data signals from one another, which discriminating device, by resorting to simple digital filters introduced prior to the effectuation of the actual data discrimination by the use of a partly-original algorithm, takes into due account data modulation rates, in order to decide whether this discrimination is to be effected or not, so as to avoid the occurrence of the above-mentioned disadvantages, in the cases in which due to the low data rate said discrimination is useless and unnecessary.

Furthermore the discriminating device performance may be improved by resorting to said digital filters even when high-rate data are concerned (3600 bit/s; 4800 bit/s), as it is based on "inverse filtering" techniques which theoretically ensure optimum discrimination. As known, the term "inverse filter" with respect to a given signal s(t) with spectrum $S(\omega)$ defines the signal whose transfer function $H(\omega)$ is the reciprocal of $S(\omega)$. For an inverse filter the maximum ratio of filter input power to the filter output power occurs for the signal s(t) for which the filter has been designed. More particularly in the device provided by the invention two inverse filters are provided one for the speech signal and the other one for speech-band modulated data signals. From the comparison between the respective energy ratios it can be deduced whether the concerned signal is a speech or a data signal.

The present invention provides a digital device for the discrimination between digital speech signals and data signals belonging to PCM frames of a speech data integrated network, said signals arriving on a common signal input, wherein to the common signal input, an unmodified signal path and two paths respectively incorporating one of two transversal digital filters used to discriminate between speech and data signals, the first filter having a transfer function equal to the inverse of the average spectrum of the speech signal and the second filter having a transfer function equal to the inverse of the average spectrum of the data signal, are connected, the output signals of these paths being supplied to a circuit comparing and processing them.

An embodiment of this invention will now be described, by way of example only, with reference to the accompanying drawings wherein:

Fig. 1 is a general scheme showing the insertion of the device provided by the invention into the telephone network,

Fig. 2 is a schematic representation of the device structure.

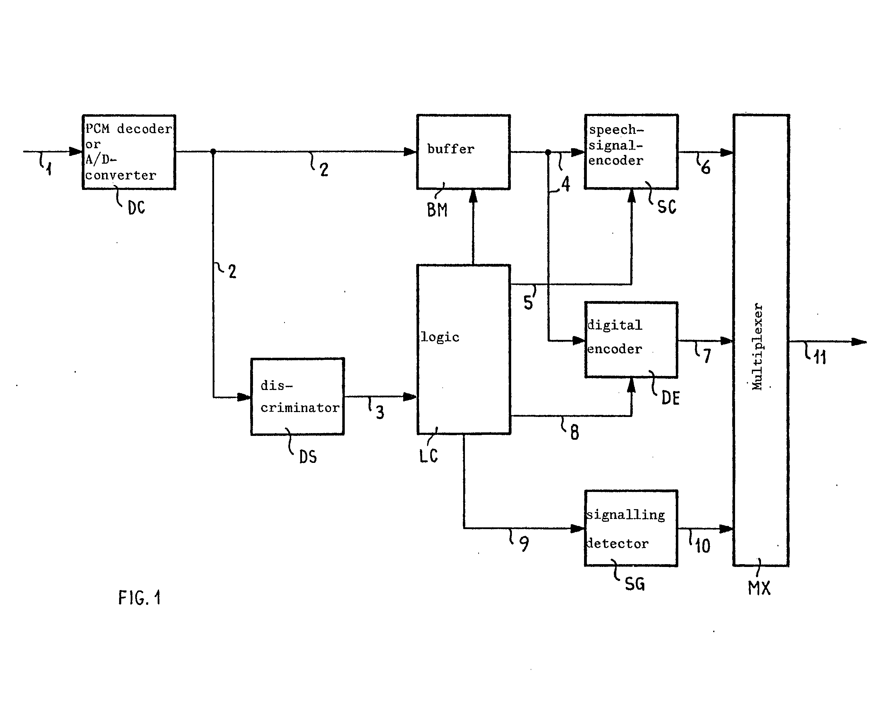

Referring to Fig. 1, DC denotes a current PCM decoder of known type apt to linearize the PCM frame bit stream it receives at the input through connection 1, and to emit it at the output, through connection 2, towards a usual buffer memory BM and towards a digital device DS for speech data signal discrimination and for high- and low-rate signal classification.

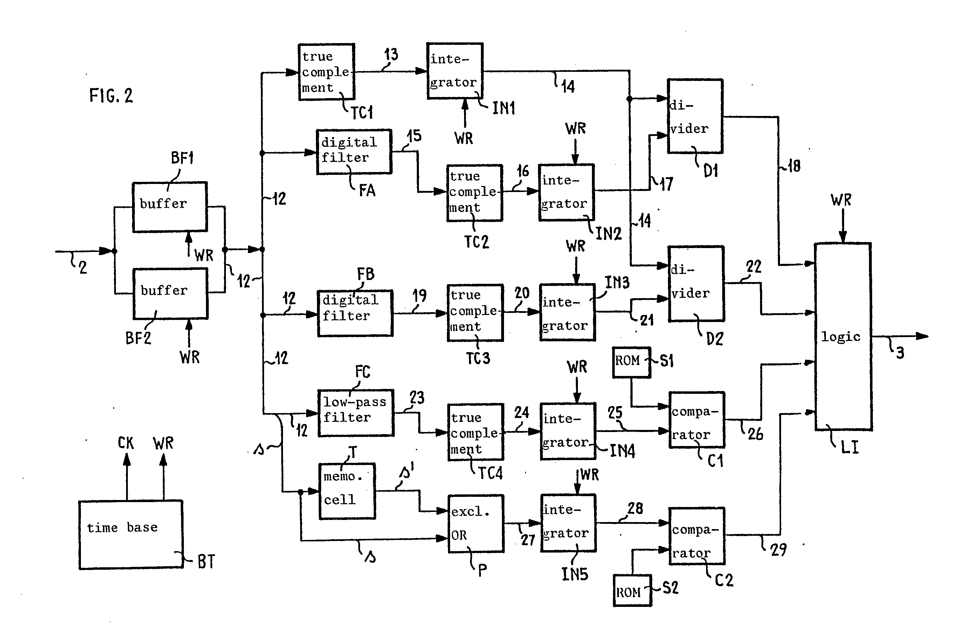

Device DS, provided by the present invention will be examined hereinafter in connection to Fig. 2.

If the signal present on connection 1 concerns a telephone channel of the analog type, DC (Fig. 1), is an analog-to-digital converter; in that way in any situation on connection 2 a linear bit stream is present.

LC denotes a logic circuit arranged to supervise the operations carried out by the blocks shown in the drawing. LC operation will be better described hereinafter when the functions of the remaining blocks are defined. The way in which a logic circuit such as LC is obtained is not a problem to those skilled in the art once its functions have been disclosed; however said circuit is not within the scope of the invention.

SC denotes a conventional digital speech-signal encoder; e.g. SC can be of the ADPCM type and then operate a differential encoding, with variable quantization step, on the speech signal it receives from BM through connection 4, once as will be seen hereinbelow said signal has been recognized as such by DS and upon the enable signal, received from LC through connection 5. The speech signal encoded in this way by SC is forwarded on transmission line 11, through connection 6 and a multiplexer MX of known type.

DE denotes a digital encoder of any known type specialized in data signal encoding, which signal it receives from BM through connection 4, once as will be seen hereinafter, said signal has been recognized as such by DS and upon the enable signal received from LC through connection 8.

SG denotes a circuit of known type arranged to forward onto line 11, through connection 10 and multiplexer MX, the information concerning the signalling contained in PCM stream (or on the analog channel) present on connection 1; said signalling formation is afterwards transferred to SG through DC, the connection 3, LC and connection 9.

As known, in the systems such as those of Fig. 1, as a rule a predetermined number of channels is assigned, equal to about 30% of the total data signal transmission, and the remaining part is intended for speech signals. This strict channel division entails a non-efficient use of transmission line 11.

Device DS intervention, as will be seen, by assigning a speech type encoding to low-rate data channels, allows considerable improvements in the transmission line efficiency. In fact data signalling encoding uses five bits at least, speech data signalling encoding needs less than five; sometimes three will be sufficient.

In Fig. 2 BF1 and BF2 denote two buffer memories of the known type, which are alternatingly written in series and read in parallel with the bits relating to the samples of the signal present on connection 2. The timing for the writing step is obtained in a known way, and hence it is not represented, by the sampling frequency of PCM signals (125 us).

The command WR for operating the read-write exchange and vice versa is generated by a conventional time base BT, which is also capable of generating the timing signal CK necessary to all the logic circuits of Fig. 2.

TC1 denotes a true complement circuit of known type connected at the input, via connection 12, to the outputs of buffer memories BF1, BF2 and at the output, via connection 13, to a conventional integrator, denoted by IN1, TC1 extracts the information relating to the modulus from the samples of the signals present on connection 12 and transmits said information to IN1.

IN1 loads, for the duration of a period of the signal WR it receives from BT, the modulus samples it receives from TC1 and emits their result at the output on connection 14 towards two digital dividers, denoted by D1, D2, which will be examined hereinafter.

FA denotes a digital filter of the transversal type having a transfer function equal to the inverse of the average spectrum of the speech signal; FA embodiment is well known to those skilled in the art. FA receives at the input the signal samples present on connection 12 and, once filtered, sends them at the output on connection 15 towards a true complement circuit TC2, of the same kind as TC1.

IN2 is an integrator analogous to IN1. The samples of the signal modulus emitted by TC2 on connection 16 towards IN2, are integrated by IN2 and emitted at the output on connection 17 towards divider D1. D1 is a divider of the known kind suited to effect the division between the signal it receives from IN1 through connection 14 and the signal it receives from IN 2 through connection 17. The division result is emitted from D1 at the output on connection 18.

FB denotes a transversal digital filter having a transfer function equal to the inverse of the average spectrum of speech-band modulated data signals; FB can be made by any person skilled in the art.

TC3 is a true complement analogous to TC1 and TC2, designed to extract the sample modulus of the signal it receives through connection 19.

IN3 is an integrator, analogous to IN1 and IN2, designed to load in the time the modulus samples it receives from TC3 through connection 20.

D2 is a divider, analogous to D1, designed to perform the division between the signal it receives from IN1 through connection 14 and the one it receives from IN3 via connection 21. The result of the division is emitted from D2 at the output on connection 22.

FC denotes a low-pass transversal digital filter of the known type with about 900 Hz cutoff frequency. TC4 is a true complement circuit, analogous to TC1, TC2 and TC3, designed to extract the modulus of the samples of the signal it receives from FC through connection 23.

IN4 is an integrator, analogous to IN1, IN2 and IN3 apt to load in time the modulus samples it receives from TC4 through connection 24.

All the integrators IN1, ..., and an integrator IN5 are reset with period equal to that of the signal WR.

C1 denotes a two-in comparator of the known type capable of making the comparison between the signal present at its first input connected to connection 25, coming from IN4, and a threshold value determined when designing C1 and equal to about 12, stored in a ROM S1, connected to the second input of C1. C1 emits at the output on wire 26 the result of the effected comparison.

s denotes the wire of connection 12 which carries the sign information.

T is a memory cell which introduces a delay equal to a period of signal CK on the sign information it recieves from wire s, emitting it at the output of wire s'.

P is a usual logic gate of the exclusive-OR type connected at the input to wires s and s'; if the two signs present on wires s and s' are different, P emits at the output on wire 27 a logic "1" toward integrator IN5.

The integrator IN5, perfecly analogous to the just examined integrators IN1, ... IN4, loads in the time the logic "1"s it receives from P, through wire 27, and emits their result at the output on connection 28; said result obviously represents the number of zero crossings of the signal present on connection 12 in a period of signal WR.

C2 denotes a comparator analogous to C1 apt to make a comparison between the signal present at its first input connected to connection 28 coming from IN5, and a threshold value determined when designing C2 and equal to about 20, stored in a ROM S2 connected to the second input of C2. C2 emits at the output on wire 29 the result of the effected comparison.

With reference to the arrangement of the mentioned circuits, reference is made to the drawings which shows the respective connections very clearly.

With reference to what has previously been said:

— the signal present on connection 14 represents the addition of the moduli of the samples, relating to a period of WR, of the signal present at the input on connection 2;
— signal present on connection 17 represents the addition of the moduli of the signal present on connection 2, but after filtering it by a filter FA, inverse with respect to the average spectrum of the speech signal;
— the signal present on connection 21 represents the addition of the moduli of the signal present on connection 2, but after filtering it by filter FB, inverse with respect to the average spectrum of speech-band modulated data signal.

As a consequence, on connections 18 and 22 there are present the ratios between the additions of the signal moduli and that of the filtered signal respectively. By these ratios, as mentioned, the kind of spectrum of the signal under test can be deducted to a good approximation and therefore a discrimination between speech and data signals can be reached.

The signal present on connection 25 represents the addition of the signal moduli under test filtered by a low-pass filter. As the data signal is voice-band modulated around a 1800 Hz carrier and, the higher the data rate the wider being its spectrum, it happens that the higher is the value of the signal present on connection 25, the higher is the probability that the data is at high rate.

The signal present on connection 28 represents the number of zero-crossings of the signal under test and co-operates in speech/data decision in the sense that a low number of zero-crossings denotes a wider probability of speech presence and vice versa.

Logic circuit L1 on the basis of the information it receives from D1, D2, C1 and C2 can decide whether the signal present on connection 2 is a speech signal, a low-rate data signal or a high-rate data signal and consequently emits at the output the information relating to the effected choice. The practical embodiment of a logic such as L1 is not a problem to the person skilled in the art, once the logic equations characterizing its operations have been defined.

Denoting by S18, S22, S25 and S28 the values assumed by the signals on the connections denoted by 18, etc.; by S1, S2 the homonymous threshold values; by sign $\wedge$ the AND logic operator, it derives that if S18 is greater than S22, and S28 is less than S2, circuit L1 emits at the output on connection 3 a signal denoting the presence of the speech signal on connection 2.

In this case then the following relationship is valid:

$$(S18>S22)\wedge(S28<S2)\rightarrow\text{speech} \quad (1)$$

If, on the contrary, the opposite conditions occur, defined by the relationship:

$$(S18<S22)\wedge(S28>S2)\rightarrow\text{data} \quad (2)$$

the signal emitted by L1 on connection 3 denotes the presence of speech band modulated data on connection 2.

L1 makes also a distinction between low-rate and high-rate data. More particularly, if S25>S1, data is at high-rate; if S25<S1, data is at low-rate.

Logic L1 is programmed so that, if the conditions defined neither by equation (1) nor by equation (2) occur, it emits the same decision as previously taken concerning the period of signal WR.

## Claims

1. Digital device for the discrimination between digital speech signals and data signals belonging to PCM frames of a speech data integrated network, said signals arriving on a common signal input (2, 12), characterized in that to the common signal input (12), an unmodified signal path (13, 14) and two paths (15, 19) respectively incorporating one of two transversal digital filters used to discriminate between speech and data signals, the first filter (FA) having a transfer function equal to the inverse of the average spectrum of the speech signal and the second filter (FB) having a transfer function equal to the inverse of the average spectrum of the data signal, are connected, the output signals of these paths being supplied to a circuit (D1, D2, L1) comparing and processing them.

2. Digital device for the discrimination between speech signals and data signals according to claim 1, characterized in that for speech-data signals discrimination the following means are provided:

— a time base (BT) arranged to emit a first (WR) and a second (CK) timing signal;
— a pair of buffer memories (BF1, BF2), alternatingly written in series and read in parallel at each period of said first timing signal (WR) designed to effect the temporaneous storage of the linear stream of samples relating to said PCM streams;
— a first true complement circuit (TC1) and a first integrator (IN1), designed to extract from the samples coming from said pair of buffer memories (BF1, BF2), the information relating to the addition of moduli of PCM samples relating to a period of said first timing signal (WR);
— said first digital transversal filter (FA), a second true complement circuit (TC2) and a second integrator (IN2) apt to extract from the samples coming from said pair of buffer memories (BF1, BF2) the information relating to the addition of the moduli of the PCM samples filtered by said first filter (FA) and relating to a period of said first timing signal (WR);
— a first digital divider (D1) designed to effect the ratio between the addition of the moduli of PCM samples coming from said first integrator (IN1) and the addition of the moduli of PCM samples filtered by said first filter (FA) coming from said second integrator (IN2);
— said second transversal digital filter (FB), a third true complement circuit (TC3) and a third integrator (IN3) designed to extract from the samples coming from said pair of buffer memories (BF1, BF2) the information relating to the addition of the moduli of PCM encoded samples filtered by said second filter (FB) and relating to a period of said first timing signal (WR);

— a second digital divider (D2) designed to perform the ratio of the addition of the moduli of PCM samples coming from said first integrator (IN1) and the addition of the moduli of PCM samples filtered by said second filter (FB) coming from said third integrator (IN3);

— a logic gate (P) of the exclusive OR type able to emit at the output a logic "1" if the samples sign it receives from said pair of buffer memories (BF1, BF2) is different from the sign, delayed by a period of said second timing signal (CK), it receives from a memory cell (T) connected at its input to said pair of buffer memories (BF1, BF2);

— a fourth integrator (IN5) capable of storing the number of logic "1s" it receives from said logic gate (P) and to supply at the output the total, referred to each period of said first timing signal (WR);

— a first comparator (C2) capable of comparing the value it receives from said fourth integrator (IN5) with a first pre-determined threshold value (S2) suitably memorized and of emitting its result at the output;

— a logic circuit (L1) able to determine depending on the values of the ratios it receives from said first (D1) and second (D2) dividers and depending also on the result of the comparison it receives from said first comparator (C2), if the signal present at the input of said pair of buffer memories (BF1, BF2) is a speech signal or a data signal.

3. Digital device for the discrimination between speech signals and data signals according to claim 1 or 2, characterized in that by the use of a third transversal digital filter (FC) of the low-pass type a further discrimination between high-rate data signals and low-rate data signals is effected.

4. Digital device for the discrimination between speech signals and data signals according to claim 3, referred to claim 2, characterized in that for the discrimination of high rate data signals from low-rate data signals the following means are provided:

— said third transversal digital filter of the low-pass type (FC), a fourth true complement circuit (TC4) and a fifth integrator (IN4) apt to exact from the samples coming from said pair of buffer memories (BF1, BF2) the information relating to the addition of the moduli of the PCM samples filtered by said third filter (FC) and relating to a period of said first timing signal (WR);

— a second comparator (C1) apt to compare the value it receives from said fifth integrator (IN4) with a second pre-determined duly stored threshold value (S1) and apt to emit its result at the output;

— said logic circuit (L1) capable of determining depending on the result of the comparison it receives from said second comparator (C1) whether the signal present at the input of said pair of buffer memories (BF1, BF2) already recognized by the same logic circuit (L1) as data signal, is at high or low rate.

5. Digital device for the discrimination between speech signals and data signals according to claim 2 or to claim 3 or 4 referred to claim 2, characterized in that said logic circuit (L1) is apt to recognize as speech signals those for which the conditions jointly take place that the value of the ratio received from said first divider (D1) is greater than that received from said second divider (D2) and that the comparison result it receives from said first comparator (C2) indicates that said first threshold value (S2) has not been exceeded.

6. Digital device for the discrimination between speech signals and data signals according to claim 2 or any of claims 3 to 5 referred to claim 2, characterized in that said logic circuit (L1) is apt to recognize as data signals those for which the conditions jointly take place that the value of the ratio received from said first divider (D1) is less than that received from said second divider (D2) and that the result of the comparison it receives from said first comparator (C2) indicates that said first threshold value (S2) has been exceeded.

7. Digital device for the discrimination between speech signals and data signals according to claim 4 or to claim 5 or 6 referred to claim 4, characterized in that said logic circuit (L1) is apt to recognize as high-rate data signals those for which the comparison result it receives from said second comparator (C1) indicates that said second threshold value (S1) has been exceeded, and to recognize as low-rate data signals those for which said second threshold value (S1) has not been exceeded.

**Patentansprüche**

1. Digital arbeitende Vorrichtung für die Unterscheidung zwischen digitalen Sprechsignalen und Datensignalen, die zu PCM-Rahmen eines für Sprache und Daten integrierenden Netzes gehören und an einem gemeinsamen Signaleingang (2, 12) eintreffen, dadurch gekennzeichnet, daß an den gemeinsamen Signaleingang (12) ein unmodifizierter Signalweg (13, 14) und zwei Wege (15, 19), die jeweils einen von zwei digitalen Transversalfiltern enthalten, die zur Unterscheidung zwischen Sprech- und Datensignalen dienen und von denen das erste Filter (FA) eine Durchgangsfunktion gleich dem Inversen des mittleren Spektrums des Sprechsignals und das zweite Filter (FB) eine Durchgangsfunktion gleich dem Inversen des mittleren Spektrums des Datensignals aufweist, angeschlossen sind und die Ausgangssignale dieser Wege einer sie vergleichenden und verarbeitenden Schaltung (D1, D2, LI) eingespeist sind.

2. Digital arbeitende Vorrichtung für die Unterscheidung zwischen Sprech- und Datensignalen nach Anspruch 1, dadurch gekennzeichnet, daß für die Unterscheidung zwischen Sprech- und Datensignalen die folgenden Einrichtungen vorhanden sind:

— ein Zeitgeber (BT), der ein erstes Zeitsignal (WR) und eine zweites Zeitsteuersignal (CK) abgibt;
— zwei Pufferspeicher (BF1, BF2), bei denen in jeder Periode des ersten Zeitsteuersignals (WR) alternierend in Serie eingeschrieben und parallel ausgelesen wird und die die vorübergehende Speicherung des linearen Flusses der Abtastwerte, die sich auf die PCM-Nachrichtenströme beziehen, bewirken;
— eine erste Basiskomplementschaltung (TC1) und ein erster Integrator (IN1), die aus den von den beiden Pufferspeichern (BF1, BF2) kommenden Abtastwerten die Information extrahieren, die sich auf die Summe von Betragswerten der PCM-Abtastwerte in einer Periode des ersten Zeitsteuersignals (WR) bezieht;
— das erste digitale Transversalfilter (FA), eine zweite Basiskomplementschaltung (TC2) und ein zweiter Integrator (IN2), die aus den von den beiden Pufferspeichern (BF1, BF2) kommenden Abtastwerten die Information extrahieren, die sich auf die Summe der Betragswerte der PCM-Abtastwerte, die vom ersten Filter (FA) gefiltert worden sind, in einer Periode des ersten Zeitsteuersignals (WR) bezieht;
— eine erste Dividierschaltung (D1), die das Verhältnis zwischen der Summe der Betragswerte der PCM-Abtastwerte, die vom ersten Integrator (IN1) kommt, und der vom zweiten Integrator (IN2) kommenden Summe der Betragswerte der PCM-Abtastwerte, die vom ersten Filter (FA) gefiltert worden sind, bildet;
— der zweite transversale Digitalfilter (FB), eine dritte Basiskomplementschaltung (TC3) und ein dritter Integrator (IN3), die aus den von den beiden Pufferspeichern (BF1, BF2) kommenden Abtastwerten die Information extrahieren, die sich auf die Summe der Betragswerte der PCM-Abtastwerte, die vom zweiten Filter (FB) gefiltert worden sind, in einer Periode des ersten Zeitsteuersignals (WR) bezieht;
— eine zweite Dividierschaltung (D2), die das Verhältnis der Summe der Betragswerte der PCM-Abtastwerte, die vom ersten Integrator (IN1) kommt, und die vom dritten Integrator (IN3) kommende Summe der Betragswerte der PCM-Abtastwerte, die vom zweiten Filter (FB) gefiltert worden sind, bildet;
— eine Exclusiv - ODER Verknüpfungsschaltung (P), die ausgangsseitig eine boolesche "1" abgibt, wenn das Vorzeichen der Abtastwerte, die sie von den beiden Pufferspeichern (BF1, BF2) empfängt, sich vom Vorzeichen der Abtastwerte, die sie von einer eingaungsseitig mit den bieden Pufferspeichern (BF1, BF2) verbundenen Speicherzelle (T) empfängt und die um eine Periode des zweiten Zeitsteuersignals (CK) verzögert sind, unterscheidet;
— ein vierter Integrator (IN5), der die Anzahl der booleschen "1", die er von der Verknüpfungsschaltung (P) empfängt, speichert und ausgangsseitig die Gesamtsumme, bezogen auf jede Periode des ersten Zeitsteuersignals (WR), abgibt;
— eine erster Komparator (C2, der den Wert, den er vom vierten Integrator (IN5) empfängt, mit einem ersten gegebenen Schwellenwert (S2), der entsprechend gespeichert ist, vergleicht und das Vergleichsergebnis ausgangsseitig abgibt;
— eine logische Schaltung (LI), die in Abhängigkeit von den Verhältniswerten, die sie von der ersten (D1) und der zweiten (D2) Dividierschaltung empfängt, und auch in Abhängigkeit vom Vergleichsergebnis, das sie vom ersten Komparator (C2) empfängt, bestimmt, ob das eingangsseitig an den beiden Pufferspeichern (BF1, BF2) vorliegende Signal ein Sprechsignal oder ein Datensignal ist.

3. Digital arbeitende Vorrichtung für die Unterscheidung zwischen Sprech- und Datensignalen nach Anspruch 1 oder 2, dadurch gekennzeichnet, daß zur weitern Unterscheidung zwischen Datensignalen hoher Rate und Datensignalen niedriger Rate ein drittes transversales digitales Tiefpaßfilter (FC) dient.

4. Digital arbeitende Vorrichtung für Unterscheidung zwischen Sprech- und Datensignalen nach dem auf Anspruch 2 bezogenen Anspruch 3, dadurch gekennzeichnet, daß für die Unterscheidung zwischen Datensignalen hoher Rate und Datensignalen niedriger Rate die folgenden Einrichtungen vorhanden sind:

— das dritte transversale digitale Tiefpaßfilter (FC), eine vierte Basiskomplementschaltung (TC4) und ein fünfter Integrator (IN4), die aus den von den beiden Pufferspeichern (BF1, BF2) kommenden Abtastwerten die Information extrahieren, die sich auf die Summe der Betragswerte der PCM-Abtastwerte, die vom dritten Filter (FC) gefiltert worden sind, in einer Periode des ersten Zeitsteuersignals (WR) beziehen;
— ein zweiter Komparator (C1), der den Wert, den er vom fünften Integrator (IN4) empfängt, mit einem zweiten gegebenen ent-

sprechend gespeicherten Schwellenwert (S1) vergleicht und das Vergleichsergebnis ausgangsseitig abgibt;
— die logische Schaltung (LI), die in Abhängigkeit vom Vergleichsergebnis, das sie vom zweiten Komparator (C1) empfängt, bestimmt, ob das eingangsseitig an den beiden Pufferspeichern (BF1, BF2) anliegende Signal, das von dieser logischen Schaltung (L1) bereits als Datensignal erkannt worden ist, eine hohe oder eine niedrige Rate aufweist.

5. Digital arbeitende Vorrichtung für die Unterscheidung zwischen Sprech- und Datensignalen nach Anspruch 2 oder einem der auf Anspruch 2 rückbezogenen Ansprüche 3 und 4, dadurch gekennzeichnet, daß die logische Schaltung (LI) solche Signale als Sprechsignale erkennt, für die die Bedingungen gemeinsam erfüllt sind, daß der von der ersten Dividierschaltung (D1) empfangene Verhältniswert größer ist als der von der zweiten Dividierschaltung (D2) empfangene Verhältniswert, und daß das Vergleichsergebnis, das sie vom ersten Komparator (C2) empfängt, anzeigt, daß der erste Schwellenwert (S2) nicht überschritten worden ist.

6. Digital arbeitende Vorrichtung für die Unterscheidung zwischen Sprech- und Datensignalen nach Anspruch 2 oder einem der auf Anspruch 2 rückbezogenen Ansprüche 3 bis 5, dadurch gekennzeichnet, daß die logische Schaltung (LI) solche Signale als Datensignale erkennt, für die die Bedingungen gemeinsam niedriger ist als der von der zweiten Dividierschaltung (D2) empfangene Verhältniswert, und niedriger ist als der von der zweiten Dividerschalutng (D2) empfangene Verhältniswert, und daß das Vergleichsergebnis, das sie vom ersten Komparator (C2) empfängt, anzeigt, daß der erste Schwellenwert (S2) überschritten worden ist.

7. Digital arbeitende Vorrichtung für die Unterscheidung zwischen Sprech- und Datensignalen nach Anspruch 4 oder nach einem der auf Anspruch 4 rückbezogenen Ansprüche 5 und 6, dadurch gekennzeichnet, daß die logische Schaltung (LI) solche Signale als Datensignale hoher Rate erkennt, für die das Vergleichsergebnis, das sie vom zweiten Komparator (C1) empfängt, anzeigt, daß der zweite Schwellenwert (S1) überschritten worden ist, und solche Signale als Datensignale niedriger Rate erkennt, für die der zweite Schwellenwert (S1) nicht überschritten worden ist.

**Revendications**

1. Dispositif numérique pour discriminer les signaux numériques vocaux ete des données, faisant partie des trames MIC d'un réseau intégré pour la voix et les données, lesdits signaux provenant sur une entrée de signal commune (2, 12), caracterisé en ce que à l'entrée de signal commune (12), une ligne de signal non-modifié (13, 14) et deux lignes (15, 19) qui comprennent respectivement un de deux filtres numériques transversaux pour discriminer les signaux vocaux des signaux des données, le premier filtre (FA) ayant une fonction de transfert égale à l'inverse du spectre moyen du signal vocal et le deuxième filtre (FB) ayant une fonction de transfert égale à l'inverse du spectre moyen du signal des données, sont connectées, les signaux de sortie de cettes lignes étant fournis à un circuit (D1, D2, LI), qui les compare et les traite.

2. Dispositif numérique pour discriminer les signaux vocaux et des données suivant le revendication 1, caracterisé en ce que pour discriminer les signaux vocaux des signaux de données, les moyens suivants sont prevus:

— une base de temps (BT) apte à émettre un premier (WR) et un second (CK) signal de synchronisation;
— une paire de mémoires tampons (BF1, BF2) alternativement écrites en série et lues en parallèle à chaque période dudit premier signal de synchronisation (WR), aptes à stocker temporairement en mémoire le flux linéaire des échantillons relatifs auxdites trames MIC;
— un premier circuit extracteur de module (TC1) et un premier intégrateur (IN1), aptes à obtenir des échantillons provenant de ladite paire de mémoires tampons (BF1, BF2) l'information relative à la somme des modules des échantillons MIC relatifs à une période dudit premier signal de synchronisation (WR);
— ledit premier filtre numérique transversal (FA), un deuxieme extracteur de module (TC2) et un deuxième intégrateur (IN2) aptes à extraire des échantillons provenant de ladite paire de mémoires tampons (BF1, BF2) l'information relative à la somme des modules d'échantillons MIC filtrés par ledit premier filtre (FA) et relatifs à une période dudit premier signal de synchronisation (WR);
— un premier diviseur (D1) apte à effectuer le rapport entre la somme des modules des échantillons MIC provenant dudit premier intégrateur (IN1) et la somme des modules des échantillons MIC filtrés par ledit premier filtre (FA) provenant dudit deuxième intégrateur (IN2);
— ledit deuxième filtre numérique transversal (FB), un troisième extracteur de module (TC3) et un troisième intégrateur (IN3) aptes à extraire des échantillons provenant de ladite paire de mémoires tampons (BF1, BF2) l'information relative à la somme des modules des échantillons MIC filtrés par ledit deuxième filtre (FB) et relatifs à une période dudit premier signal de synchronisation (WR);
— un deuxième diviseur (D2) apte à effectuer le rapport entre la somme des modules des échantillons MIC provenant dudit premier intégrateur (IN1) et la somme des modules des échantillons MIC, filtrés par ledit deuxiéme filtre (FB), provenant dudit troisième intégrateur (IN3);

— une porte logique (P) du type OR exclusif apte à émettre à la sortie un "1" logique si le signe des échantillons, qu'elle reçoit de ladite paire de mémoires tampons (BF1, BF2), est différent du signe, retardè d'une période dudit signal de synchronisation (CK), qu'elle reçoit d'une cellule de mémoire (T) connectée à l'entrée de ladite paire de mémoires tampons (BF1, BF2);

— une quatrième intégrateur (IN5) apte à accumuler le nombre des "1" logique qu'il reçoit de ladite porte logique (P) et à fournir à la sortie le total référé à chaque période dudit premier signal de synchronisation (WR);

— un premier comparateur (C2) apte à comparer la valeur qu'il reçoit dudit quatrième intégrateur (IN5) avec une première valeur de seuil prédéterminée (S2) stockée en mémoire et à en émettre le résultat à la sortie;

— un circuit logique (LI) apte à décider sur la base des valeurs des rapports, qu'il reçoit dudit premier (D1) et deuxième (D2) diviseurs, et du résultat de la comparaison qu'il reçoit dudit premier comparateur (C2), si le signal présent à l'entrée de ladite paire de mémoires tampons (BF1, BF2) ets un signal vocal ou un signal de données.

3. Dispositif numérique pour discriminer les signaux vocaux et des données suivant la revendication 1 ou 2, caracterisé en ce que par l'utilisation d'un troisième filtre numérique transversal (FC) du type passebas une ultérieure discrimination entre les signaux de données à haut débit et à bas débit est effectuée.

4. Dispositif numérique pour discriminer les signaux vocaux et des données suivant la revendication 3 référée à la rev. 2, caracterisé en ce que pour la discrimination des signaux de données à haut débit des signaux de donnèes à das débit il est prévu les moyens suivants:

— ledit troisième filtre numérique transversal du type passe bas (FC), un quatrième extracteur de module (TC4) et un cinquième intégrateur (IN4) aptes à prélever des échantillons provenant de ladite paire de mémoires tampons (BF1, BF2) l'information relative à la somme des modules des èchantillons MIC filtrés par ledit troisième filtre (FC) et relatifs à une période dudit premier signal de synchronisation (WR);

— un deuxième comparateur (C1) apte à comparer la valeur qu'il reçoit dudit cinquième intégrateur (IN4) avec une deuxième valeur prédéterminée de seuil (S1) stockée en mémoire et à en émettre le résultat à la sortie;

— ledit circuit logique (LI) apte à décider, sur la base du résultat de la comparaison qu'il reçoit dudit deuxième comparateur (C1), si le signal présent à l'entrée de ladite paire de mémoires tampons (BF1, BF2), déjà reconnu par le même circuit loqique (LI) comme un signal de données, est à haut ou bas débit.

5. Dispositif numérique pour discriminer les signaux vocaux et de données suivant la revendication 2, ou la revendication 3 ou 4 référée à la rev. 2, caractérisé en ce que ledit circuit logique (LI) reconnaît les signaux vocaux, quand les conditions se vérifient, suivant lesquelles la valeur de rapport reçu dudit premier diviseur (D1) est plus grande que la valeur reçue dudit deuxième diviseur (D2) et que le résultat de la comparaison qu'il reçoit dudit premier comparateur (C2) signifie que la première valeur de seuil (S2) n'a pas été dépassée.

6. Dispositif numérique pour discriminer les signaux vocaux et de données suivant la revendication 2 ou n'importe quelle revendication de 3 à 5 référée à la 2, caractérisé en ce que ledit circuit logique (LI) reconnaît les signaux des données quand les conditions se vérifient, que la valeur du rapport reçue dudit premier diviseur (D1) est plus petite que la valeur reçue dudit deuxième diviseur (D2) et que le résultat de la comparaison qu'il reçoit dudit premier comparateur (C2) signifie que ladite première valeur de seuil (S2) a été dépassée.

7. Dispositif numérique pour discriminer les signaux vocaux et de données suivant la revendication 4 ou la revendication 5 ou 6 référée à la revendication 4, caractérisé en ce que ledit circuit logique (LI) reconnaît les signaux des données à haut débit quand le résultat de la comparaison qu'il reçoit dudit deuxième comparateur (C1) signifie que ladite deuxième valeur du seuil (S1) a été dépassée et reconnaît les signaux des données à bas débit quand ladite deuxième valeur de seuil (S1) n'a pas été dépassée.

FIG. 1

0058982

FIG. 2